Europäisches Patentamt

European Patent Office

Office européen des brevets

(11) Publication number: **0 197 211**
**B1**

(12) **EUROPEAN PATENT SPECIFICATION**

(45) Date of publication of patent specification: **05.07.89**

(51) Int. Cl.⁴: **G 03 B 41/00, G 03 F 7/20, H 05 H 7/04, G 21 K 1/06**

(21) Application number: **85302405.7**

(22) Date of filing: **04.04.85**

(54) **X-ray exposure system.**

(43) Date of publication of application:
**15.10.86 Bulletin 86/42**

(45) Publication of the grant of the patent:
**05.07.89 Bulletin 89/27**

(84) Designated Contracting States:
**DE FR GB NL**

(56) References cited:
**EP-A-0 083 394**
**JOURNAL OF APPLIED PHYSICS, vol. 47, no. 12, December 1976, pages 5450-5459, American Institute of Physics, New York, US; E. SPILLER et al.: "Application of synchrotron radiation to x-ray lithography"**
**NUCLEAR INSTRUMENTS & METHODS IN PHISICS RESEARCH, vol. 195, no. 1/2, April 1982, pages 155-162, North-Holland Publishing Co., Amsterdam, NL; R.W. KLAFFKY et al.: "The national synchrotron light source VUV and soft x-ray beam lines: performance characteristics"**

(73) Proprietor: **HITACHI, LTD.**
**6, Kanda Surugadai 4-chome Chiyoda-ku Tokyo (JP)**

(72) Inventor: **Kimura, Takeshi**
**11-18, Meguridacho-2-chome Higashimurayama-shi (JP)**
Inventor: **Mochiji, Kozo**
**17-3-301, Oiwakecho Hachioji-shi (JP)**
Inventor: **Asai, Shojiro**
**3602-6, Kawajiri, Shiroyamacho Tsukui-gun Kanagawa-ken (JP)**
Inventor: **Obayashi, Hidehito**
**863 Walnut Avenue Burlingame, C.A. 94010 (US)**

(74) Representative: **Calderbank, Thomas Roger et al**
**MEWBURN ELLIS & CO. 2/3 Cursitor Street London EC4A 1BQ (GB)**

## Description

The present invention relates to an X-ray system having several utilization apparatuses, at least one of which is an X-ray exposure apparatus for duplicating a mask pattern on a radiation sensitive material placed at the back of an X-ray mask. The mask and the material are irradiated with synchrotron radiation.

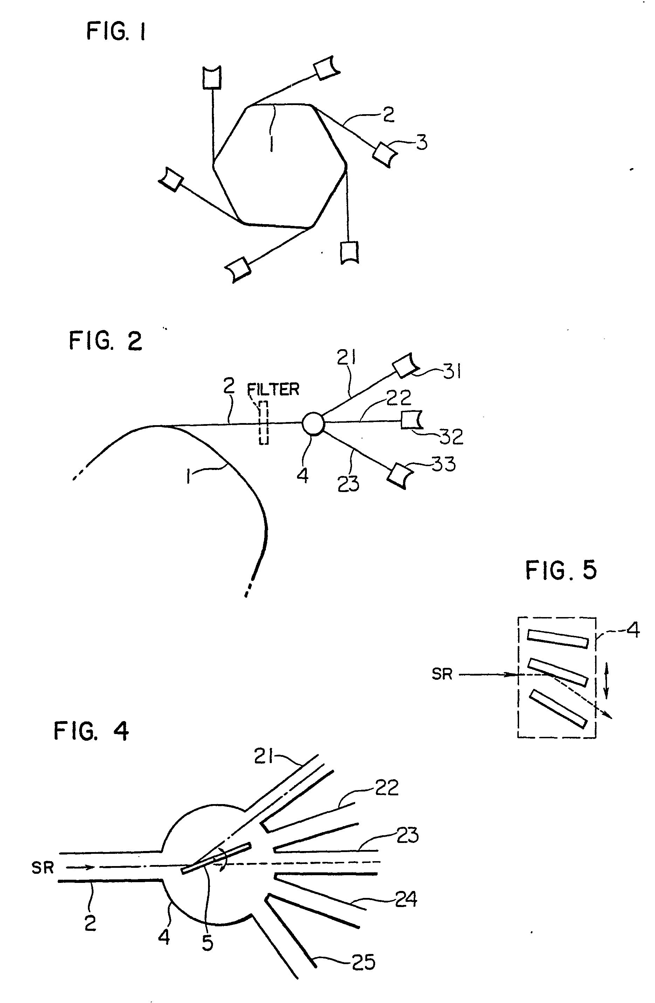

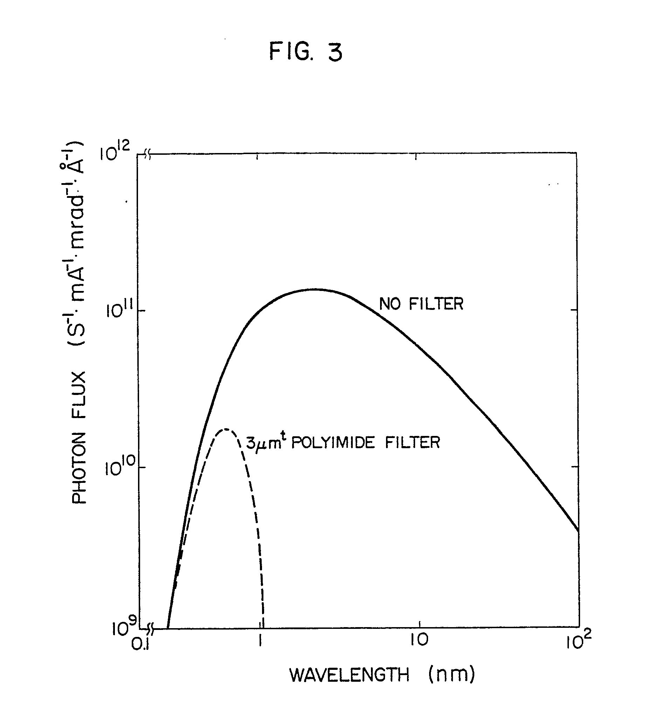

X-ray exposure apparatuses for carrying out X-ray duplication by synchrotron radiation (hereinafter simply referred to as "SR") have hitherto been arranged as shown in Fig. 1. That is, the SR emitted from a synchrotron (storage) ring 1 is taken out through a plurality of beam ducts 2, and an exposure apparatus 3 is provided at the end of each beam duct 2. Such an arrangement has been reported e.g. by R. P. Haelbich et al (members of IBM), at the 3rd National Conference on Synchrotron Radiation Instrumentation held on Sept. 12 through 15, 1983.

In the arrangement of Fig. 1, the exposure stations 3 are individually located around the synchrotron ring 1, and therefore a plurality of facilities and operators are required to operate the respective exposure stations.

Generally speaking, in the case where a circuit pattern is formed on a silicon wafer by an X-ray exposure apparatus, time required for loading and unloading the silicon wafers in the X-ray exposure apparatus and time required for aligning an X-ray mask with the silicon wafer are far longer than time required for irradiating the X-ray mask and silicon wafer with SR. Further, the SR is emitted continuously from the synchrotron ring 1. Accordingly, in the arrangement of Fig. 1, the SR passes through a beam duct 2 wastefully over a long period other than an exposure time, and thus each exposure station 3 is considered to be low in utilization efficiency of SR.

It is apparent that this arrangement is inconvenient for utilizing the exposure stations 3 and utilization efficiency would be much increased if the exposure stations were concentrated at a single beam duct 2.

It is known to split an SR beam using a grazing incidence mirror and to introduce the resulting beams simultaneously into two sample chambers (E. Spiller et al, Journal of Applied Physics, Vol. 47. No. 12, December 1976, p. 5450—5459) and the disclosure of this document corresponds to the precharacterizing part of claim 1.

However, such an arrangement introduces SR into the sample chambers continually and the utilization efficiency of each chamber remains low.

The present invention seeks to provide an X-ray system which can eliminate the drawbacks of the prior art and is high in utilization efficiency of SR.

According to the present invention there is provided an X-ray system including a plurality of utilization apparatuses including an X-ray exposure apparatus for duplicating a mask pattern on a radiation-sensitive material with synchrotron radiation, in which a synchrotron radiation path branching device is disposed between the source of the synchrotron radiation and the utilizing apparatus, to change the propagation direction of the synchrotron radiation emitted from said source so that said synchrotron radiation can be sequentially introduced into each of said utilization apparatuses.

It is preferable to employ a mirror, e.g. a rotatable mirror to change the propagation direction of the synchrotron radiation. The use of a rotatable mirror to change the direction of propagation is known from EP—A—0083394, but this utilizes the rotating mirror to provide uniform illumination of an area with synchrotron radiation, at a single utilization apparatus.

An embodiment of the invention will now be described in detail, by way of example, with reference to the accompanying drawings, in which:

Fig. 1 is a schematic diagram showing the conventional arrangement of X-ray exposure apparatuses which use SR, and has already been discussed;

Fig. 2 is a schematic diagram for explaining an embodiment of an X-ray exposure system according to the present invention;

Fig. 3 is a graph showing spectra of SR;

Figs. 4 and 5 are schematic diagrams showing examples of the branching section 4 of Fig. 2.

Referring to Fig. 2 which shows an embodiment of an X-ray exposure system according to the present invention, the SR having passed through the beam duct 2 can travel in three directions with the aid of the branch part 4, that is, can reach the X-ray exposure apparatuses 31, 32 and 33 through the sub-ducts 21, 22 and 23, respectively. Now, let us consider the case where the synchrotron ring 1 is operated under conditions that the electron acceleration energy is equal to $1 \times 10^9$ eV, the magnetic field intensity for deflecting an electron beam is equal to 1.1 T, and the average value of storage current is equal to 100 mA. Then, the SR emitted from the synchrotron ring 1 has a spectrum such as indicated by a solid line in Fig. 3. That is, a maximum number of photons are generated at a wavelength of about 15 Å (namely, 1.5 nm). Incidentally, a broken line shown in Fig. 3 indicates the spectrum of the SR having passed through a long-wavelength cutoff filter or short-wavelength pass filter which is made of polyimide resin and has a thickness of 3 μm, and the SR in the wavelength range indicated by the broken line can be used for the X-ray pattern duplication.

Fig. 4 shows an example of the branching unit 4, in which a reflecting mirror has a high reflectivity for SR so that the above SR can travel in five directions. Referring to Fig. 4, a reflecting mirror 5 is a rotatable plane mirror, both principal surfaces of which are coated with gold. The rotating axis of the mirror 5 is removed from the optical path of an SR beam emerging from a beam duct 2. The angle between the reflecting mirror 5 and the optical path of the SR beam emerging from the beam duct 2 is changed by control means (not shown) so that the SR beam can pass through each of sub-ducts 21 to 25. In more detail, the SR beam having passed through the beam duct 2 is introduced into the sub-duct 23, without being reflected by the mirror 5. While, the SR beam reflected from the mirror 5 is introduced into one of the sub-ducts 21, 22, 24 and 25.

As mentioned previously, the rotating axis of the reflecting mirror 5 is removed from the optical path of the SR beam emerging from the beam duct 2. Accordingly, the effective area for reflecting SR varies with the selection of the reflection angle, i.e. selection of the sub-ducts 21 to 25. Thus, the radiation damage to the reflecting mirror 5 is mitigated, and hence its life is greatly increased.

In the present embodiment, the propagation direction of SR is changed by rotating the reflecting mirror 5 included in the branching unit 4. Alternatively, as shown in Fig. 5, fixed-angle reflection mirrors, one for each branched optical path, may be used in place of a rotating mirror. In this case, one mirror for a desired sub-duct is inserted in the optical path of the SR beam and other mirrors designated for other sub-ducts are displaced from the optical path, according to necessity. Needless to say, such a branching unit can produce similar effects as the branching unit 4 of the present embodiment. As an alternative of the X-ray exposure apparatus 31—33 shown in Fig. 2 an SR utilization apparatus, such as a thin-film vapor growth apparatus or a dry etching apparatus may be located.

In the present embodiment, the SR beam from the beam duct 2 is introduced into three sub-ducts 21 to 23 or five sub-ducts 21 to 25. However, the present invention is not limited to such a case, but the SR beam from the beam duct 2 can be introduced into a desired number of sub-ducts.

As is evident from the foregoing explanation, according to the present invention, the utilization efficiency of SR and the practicability of X-ray exposure apparatus are greatly improved. Thus, the present invention is very effective for putting X-ray lithography to practical use.

## Claims

1. An X-ray system comprising a plurality of utilization apparatuses including an X-ray exposure apparatus for duplicating a mask pattern on a radiation sensitive material placed at the back of an X-ray mask, by irradiating the X-ray mask and the radiation sensitive material with synchrotron radiation, a synchrotron radiation path branching device (4) being disposed between the source of the synchrotron radiation and the utilization apparatuses (31 to 33), to change the propagation direction of the synchrotron radiation emitted from said source characterized in that said synchrotron radiation beam is sequentially switched to each of said utilization apparatuses by said path branching device (4).

2. An X-ray system according to claim 1, wherein said synchrotron radiation path branching device (4) includes a reflecting mirror (5) therein, and the propagation direction of the synchrotron radiation emitted from said source is changed by said reflecting mirror.

3. An X-ray system according to claim 1, wherein the synchrotron radiation emitted from said source is directed by said synchrotron radiation path branching device (4) to the X-ray exposure apparatuses (31 to 33) in a time divisional fashion so that said synchrotron radiation beam is switched to an X-ray exposure apparatus (31, 32 or 33) having completed the alignment between the X-ray mask and the radiation sensitive material.

4. An X-ray system according to claim 1, wherein the plurality of utilization apparatuses include at least one of a thin film vapour growth apparatus and a dry etching apparatus.

5. An X-ray system according to claim 2, wherein said reflecting mirror (5) is rotatable, and the rotating axis of said reflecting mirror (5) is displaced from the propagation direction of synchrotron radiation incident upon said reflecting mirror.

6. An X-ray system according to claim 1, wherein a plurality of reflecting mirrors for directing the synchrotron radiation emitted from said source, to said X-ray exposure apparatuses are provided in said synchrotron radiation path branching device (4), and a selected one of said reflecting mirrors is inserted on the optical path of said synchrotron radiation, to switch said synchrotron radiation beam into a corresponding one of said X-ray exposure apparatuses.

## Patentansprüche

1. Röntgensystem mit mehreren Anwendungsgeräten, die eine Röntgenstrahl-Belichtungsvorrichtung zum Reproduzieren einer Maskenstruktur auf ein strahlungsempfindliches Material enthalten, das auf der Rückseite einer Röntgenstrahlmaske angeordnet ist, indem die Röntgenstrahlmaske und das strahlungsempfindliche Material mit Synchrotronstrahlung bestrahlt werden, wobei eine Synchrotronstrahlungsgang-Verzweigungsvorrichtung (4) zwischen der Quelle der Synchrotronstrahlung und den Anwendungsgeräten (31 bis 33) angeordnet ist, um die Ausbreitungsrichtung der von der Quelle emittierten Synchrotronstrahlung zu ändern, dadurch gekennzeichnet, daß der Strahl der Synchrotronstrahlung durch die Strahlungsgang-Verzweigungsvorrichtung (4) der Reihe nach auf jedes der Anwendungsgeräte gelenkt wird.

2. Röntgensystem nach Anspruch 1, wobei die Synchrotronstrahlungsgang-Verzweigungsvorrichtung (4) einen reflektierenden Spiegel (5) enthält und die Ausbreitungsrichtung der von der Quelle emittierten Synchrotronstrahlung durch diesen reflektierenden Spiegel geändert wird.

3. Röntgensystem nach Anspruch 1, wobei die von der Quelle emittierte Synchrotronstrahlung durch die Synchrotronstrahlungsgangs-Verzweigungsvorrichtung (4) nach einem Zeitaufteilungsverfahren so auf die Röntgenstrahl-Belichtungsvorrichtungen (31 bis 33) gerichtet wird, daß der Strahl der Synchrotronstrahlung auf eine Röntgenstrahl-Belichtungsvorrichtung (31, 32 oder 33) gelenkt wird, bei der die Ausrichtung zwischen der Röntgenstrahlmaske und dem strahlungsempfindlichen Material abgeschlossen ist.

4. Röntgensystem nach Anspruch 1, wobei die mehreren Anwendungsgeräte zumindest ein Gerät, bei dem ein Dünnfilmwachstum aus der Dampfphase erfolgt, oder ein Trockenätz-Gerät enthalten.

5. Röntgensystem nach Anspruch 2, wobei der reflektierende Spiegel (5) drehbar ist und die Drehachse des reflektierenden Spiegels (5) gegenüber der Ausbreitungsrichtung der auf den reflektierenden Spiegel auftreffenden Synchrotronstrahlung versetzt ist.

6. Röntgensystem nach Anspruch 1, wobei mehrer reflektierende Spiegel zum Richten der von der Quelle emittierten Synchrotronstrahlung auf die Röntgenstrahl-Belichtungsvorrichtungen in der Synchrotronstrahlungsgang-Verzweigungsvorrichtung (4) vorgesehen sind und ein bestimmter der reflektierenden Spiegel in den optischen Weg der Synchrotronstrahlung eingefügt wird, um den Strahl der Synchrotronstrahlung auf eine entsprechende Röntgenstrahl-Belichtungsvorrichtung zu lenken.

## Revendications

1. Système radiographique, comprenant une pluralité de dispositifs d'utilisation incluant un dispositif d'exposition aux rayons X servant à reproduire la configuration d'un masque sur un matériau sensible au rayonnement, placé sur la face arrière d'un masque d'exposition aux rayons X, en irradiant le masque d'exposition rayons X et le matériau sensible au rayonnement au moyen d'un rayonnement synchrotron, un dispositif (4) de dérivation du trajet du rayonnement synchrotron étant disposé entre la source du rayonnement synchrotron et les dispositifs d'utilisation (31 à 33), de manière à modifier la direction de propagation du rayonnement synchrotron émis par ladite source, caractérisé en ce que ledit faisceau de rayonnement synchrotron est commuté successivement sur chacun desdits dispositifs d'utilisation, par ledit dispositif (4) de dérivation du trajet.

2. Système radiographique selon la revendication 1, dans lequel le dispositif (4) de dérivation du trajet du rayonnement synchrotron contient en lui un miroir réfléchissant (5), et la direction de propagation du rayonnement synchrotron émis par ladite source est modifié par ledit miroir réfléchissant.

3. Système radiographique selon la revendication 1, dans lequel le rayonnement synchrotron émis par ladite source est dirigé par ledit dispositif (4) de dérivation du trajet du rayonnement synchrotron en direction des dispositifs d'exposition aux rayons X (31 à 33), selon un mode à division du temps de telle sorte que ledit faisceau de rayonnement synchrotron est commuté sur un appareil d'exposition aux rayons X (31, 32 ou 33), dans lequel l'opération d'alignement entre le masque d'exposition aux rayons X et le matériau sensible au rayonnement est terminé.

4. Système radiographique selon la revendication 1, dans lequel les différents dispositifs d'utilisation incluent un dispositif de croissance d'une pellicule mince en phase vapeur et/ou un dispositif de corrosion à sec.

5. Système radiographique selon la revendication 2, dans lequel ledit miroir réfléchissant (5) est rotatif et l'axe de rotation dudit miroir réfléchissant (5) est décalé par rapport à la direction de propagation du rayonnement synchrotron tombant sur ledit miroir réfléchissant.

6. Système radiographique selon la revendication 1, dans lequel plusieurs miroirs réfléchissants servant à diriger le rayonnement synchrotron émis par ladite source sur lesdits dispositifs d'exposition aux rayons X sont prévus dans ledit dispositif (4) de dérivation du trajet du rayonnement synchrotron, et l'un sélectionné desdits miroirs réfléchissants est inséré dans le trajet optique du rayonnement synchrotron, afin de commuter ledit faisceau de rayonnement synchrotron sur un dispositif correspondant faisant partie desdits dispositifs d'exposition aux rayons X.

FIG. I

FIG. 2

FIG. 5

FIG. 4

FIG. 3